# EUROPEAN PATENT SPECIFICATION

(11) **EP 1 376 763 B1**
(45) Date of publication and mention of the grant of the patent: **18.01.2006**
(21) Application number: 03019503.6
(22) Date of filing: 19.10.2000
(51) Int. Cl.: H01R 4/02, H01R 43/02, H05K 3/30

(54) **Electrical connector with strain relief and method of securing an electrical connector to a substrate**
Elektrischer Verbinder mit Zugentlastung und Verfahren zur Befestigung eines elektrischen Verbinders an einem Substrat
Connecteur électrique à soulagement de traction et méthode pour fixer un connecteur électrique sur un substrat

(30) Priority: 19.10.1999 US 160482 P
(43) Date of publication of application: 02.01.2004
(62) Divisional of application: 00122278.5
(73) Proprietor: FCI, 78000 Versailles (FR)
(72) Inventor: Hahn, Marlyn E., York Pensylvania 17404 (US); Kline, Stanley A., Etters Pennsylvania 17319 (US); Shuey, Joseph B., Camp Hill Pennsylvania 17011 (US)
(74) Representative: Beetz & Partner

(56) References cited:
- EP-A- 0 651 471
- US-A- 4 217 024
- US-A- 5 760 469
- US-A- 5 805 427
- US-A- 5 810 607

## Description

### Background of the Invention

### 1. Field of the Invention

The invention relates to electrical connectors. More specificially, the invention relates to electrical connectors with strain relief features and to a method of securing an electrical connector to a substrate.

### 2. Brief Description of Earlier Developments

Various types of electrical connectors rely upon surface mount technology (SMT) to secure the connector's contacts to an underlying substrate. SMT connectors provide numerous benefits over earlier connectors, such as simplified manufacturing and lower costs.

While providing such advantages, the use of SMT may raise other issues. One concern, for example, involves the ability of the solder joint between the contact and the underlying substrate to absorb forces caused by, for example, shipping, handling, mating and thermal cycling. Should one solder joint become unusable as a result of damage from any of these events, the entire connector adversely may be affected.

Ball grid array (BGA) technology is one type of SMT. Generally, an electrical connector using a BGA has a housing with a contact therein. A fusible element, typically a solder ball, secures to each contact. The solder balls serve as the primary connection between the contact and the surface of the substrate. A reflow process fuses the solder ball to the substrate. During the reflow process, a beneficial "self-centering" feature of the BGA technology occurs. Specifically, as the solder reflows, the surface tension of the solder helps to align the connector properly with the conductive pads on the underlying substrate.

As with SMT connectors, forces on the solder joint in a BGA connector also poses a concern. Because of the self-centering ability of BGA connectors, however, many of the solutions used in SMT connectors cannot be used on BGA connectors. Therefore, a need exists to develop techniques for providing strain relief to BGA connectors. Which is considered to represent the closest prior art.

U.S. Patent No. 5,805,427 relates to a surface mount package comprising a standoff to reduce stresses applied to the solder balls.

### Summary of the Invention

It is an object of the invention to provide an electrical connector with strain relief features allowing a proper soldering of an unbalanced BGA connector.

These and other objects of the invention are achieved by an electrical connector mountable to a substrate according to the independent claim. The electrical connector comprises a housing, and a surface mount contact and hold down both secured to the housing. The hold down may be a surface mount hold down. The connector may further comprise a shield generally surrounding the housing, wherein the hold down is part of the shield. The surface mount contact may include a fusible element in the form of a solder ball. The surface mount contacts may form a matrix array. Also, the electrical connector may be constructed such that it remains substantially parallel when mounted to the substrate. The electrical connector may include a standoff secured to the housing, wherein the standoff is adapted to retain the housing a distance from a surface of the substrate. The standoff may be a part of the shield.

These and other objects of the invention are achieved by a ball grid array connector comprising a housing, a plurality of contacts within the housing, a plurality of fusible elements secured to the contacts for mounting the connector to a substrate, and a hold down secured to the housing. The hold down may be a surface mount hold down. The ball grid array connector may further comprise a shield generally surrounding the housing, wherein the hold down is part of the shield. Also, the ball grid array connector may include a standoff extending from the housing and adapted to retain the housing a distance from a surface of the substrate. The standoff may be a part of the shield. The ball grid array connector may be constructed such that it remains substantially parallel when mounted to the substrate.

These and other objects of the invention are achieved in one aspect of the invention by a method of mounting an electrical connector to a substrate according to claim 3. The method comprises providing a substrate and an electrical connector having a contact and a hold down, and securing the contact and the hold down to the substrate. The contact may be secured to a surface of the substrate. The contact may be secured before the hold down is secured, using a soldering technique, for example, to permit the connector to self-center on the substrate. The electrical connector may include a shield that is secured to the substrate. The method may further comprise constructing the electrical connector such that it remains substantially parallel when mounted to the substrate. Also, the method may comprise balancing the electrical connector on the substrate such that the electrical connector remains substantially parallel to the substrate during they are attached. The electrical connector may be a ball grid array connector.

These and other objects of the invention are achieved in one aspect of the invention by a method of securing an electrical connector to a substrate according to claim 3. The method comprises providing a substrate and an electrical connector having a contact and a hold down, and mounting the contact to the substrate. The method further comprises balancing the electrical connector on the substrate such that the electrical connector remains substantially parallel to the substrate during the forming of the first and second solder joints. Such balancing may be accomplished by removing material from and/or adding material to the electrical connector. Alternatively, the balancing may be accomplished by exerting an external force on the electrical connector and/or the substrate during the forming of the first and second solder joints.

These and other objects of the invention are achieved in one aspect of the invention by an improved array connector having a plurality of fusible elements that are able to support a nominal mass without an undesired flattening of the fusible elements. The nominal mass is less than a mass of the connector. The improvement comprises a feature on the connector that prevents the undesired flattening of the fusible elements. The feature may comprise a standoff. Alternatively, the feature may comprise an area of material removed from a housing of the connector.

These and other objects of the invention are achieved in one aspect of the invention by an electrical connector mountable to a substrate according to claim 1, having an array of fusible elements, and exhibiting an unbalance relative to the fusible elements, comprising a feature on the connector that prevents the unbalance from causing an undesired skewing of the connector when mounting the connector to the substrate, the feature comprising a standoff and the feature comprising an area of material removed from a housing of the connector.

### Brief Description of the Drawings

Other uses and advantages of the invention will become apparent to those skilled in the art upon reference to the specification and the drawings, in which:
Figure 1 is a top perspective view of a first alternative embodiment of the invention;
Figure 2A is a bottom perspective view of the electrical connector in Figure 1;
Figure 2B is a side view of the electrical connector in Figure 1;
Figure 3 is a top perspective view of a second alternative embodiment of the invention;
Figure 4A is a bottom perspective view of the electrical connector in Figure 3;
Figure 4B is a bottom perspective view of the electrical connector in Figure 3 with an alternative housing embodiment; and
Figure 5 is a perspective view of the electrical connector in Figure 3 modified to ensure that the connector remains substantially parallel to the substrate during a reflow process, according to the invention.

### Detailed Description of the Preferred Embodiments

Each of the alternative embodiments described herein relates to surface mounted electrical connectors having strain relief features. Preferably, fusible elements, such as solder balls, secure the contacts to conductive elements on the substrate using ball grid array (BGA) technology. Because during reflow BGA connectors tend to precisely align relative to the conductive pads on the substrate (known as "self-centering"), the strain relief features discussed herein preferably do not interfere with this desirable characteristic. Each alternative embodiment will now be described in more detail.

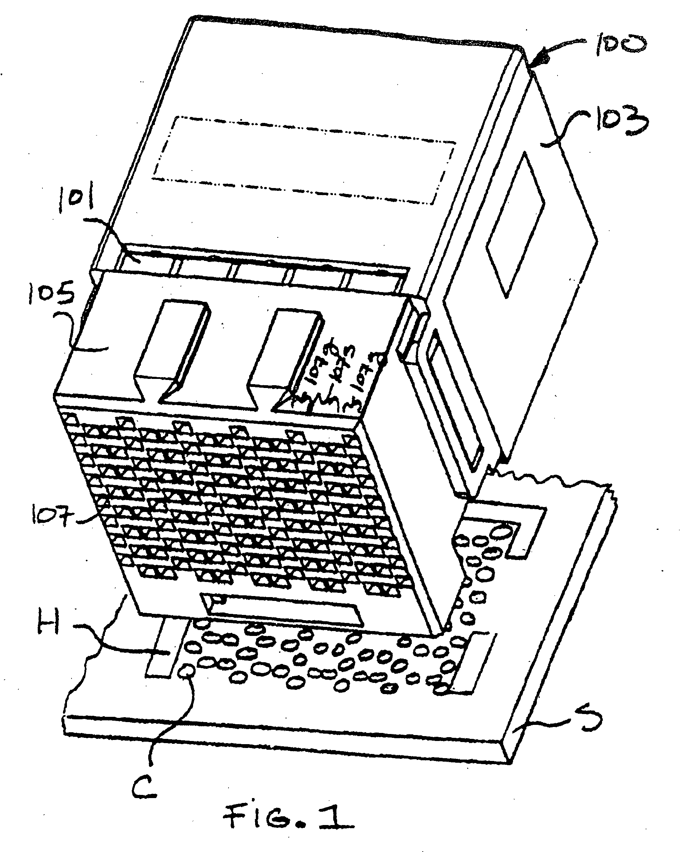

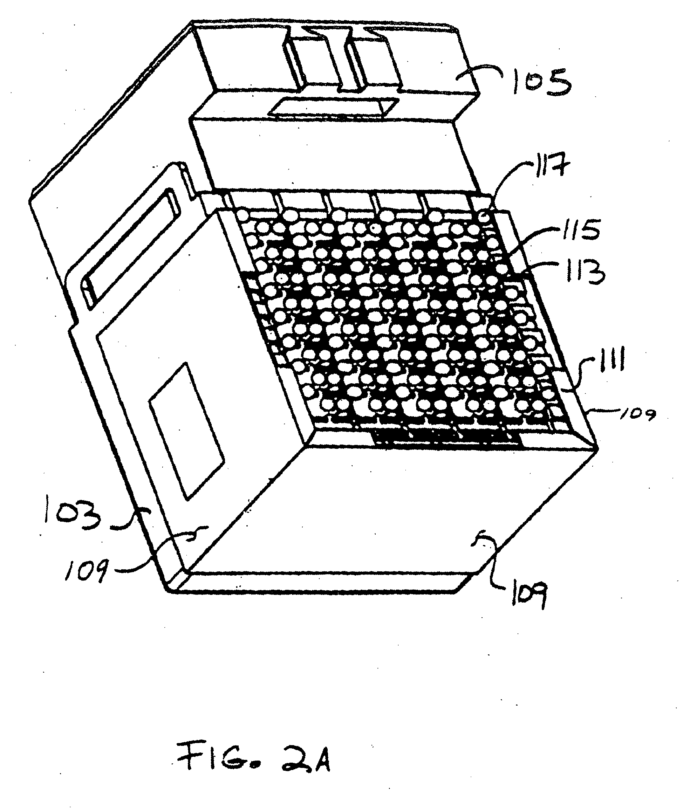

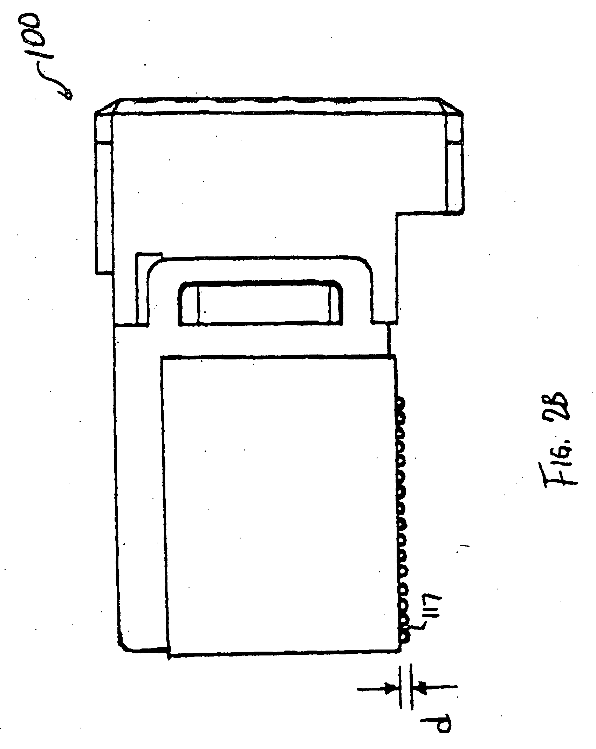

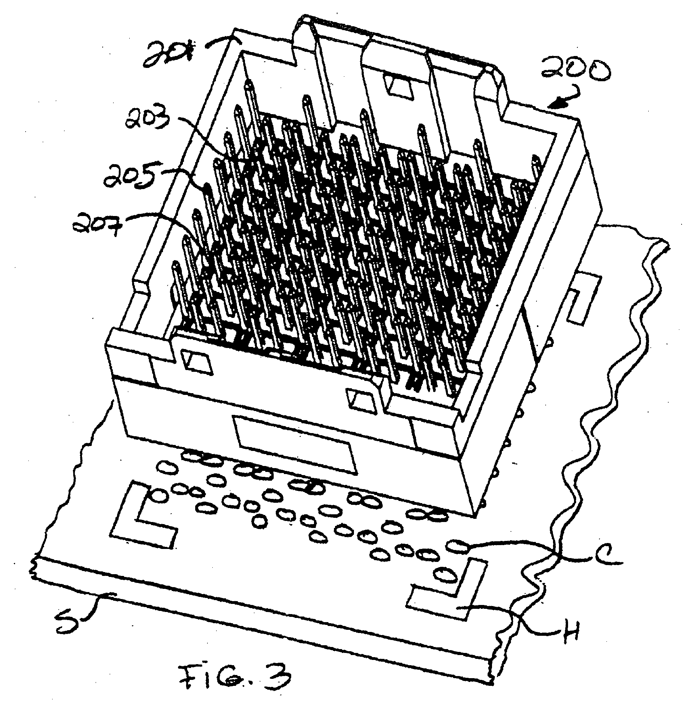

Figures 1, 2A and 2B display electrical connector 100. Receptacle backplane connector 100 uses many of the features described in U.S. Patent No. 6,116,926. Because a detailed discussion of the interior features of connector 100 are unnecessary for an understanding of the invention, only a brief summary of the interior features follows.

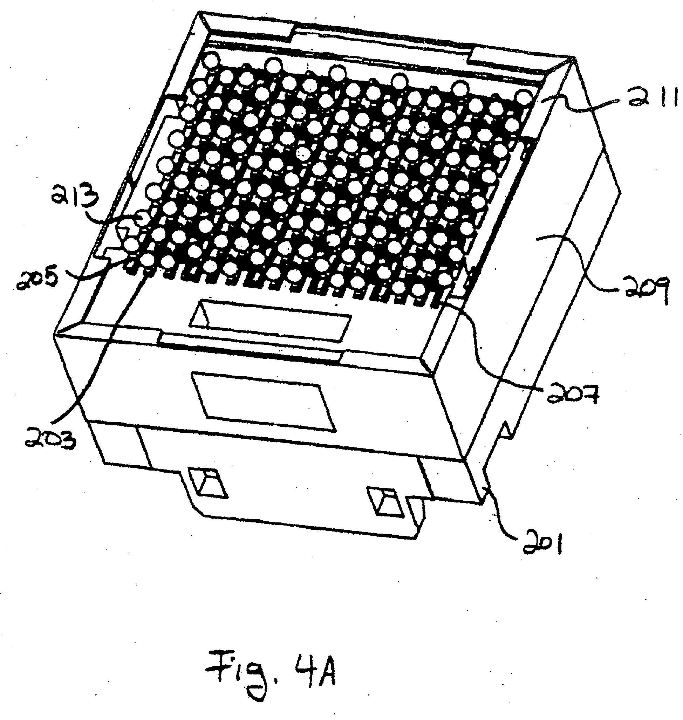

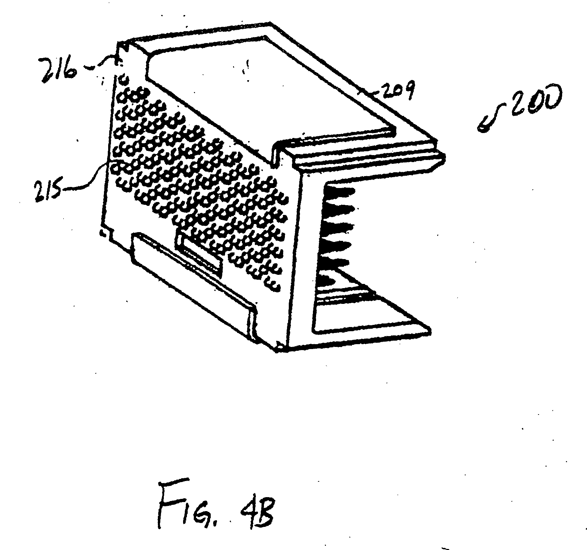

Connector 100 is modular, formed by a series of sub-assemblies 101. Rear insulative housing 103 and front insulative housing 105 can latch together and surround sub-assemblies 101 to form connector 100. Front housing 105 includes lead-in openings 107 that accept conductive pins from a mating connector (as shown in Figures 3, 4A and 4B). Openings 107 form a differential pair arrangement, with two rows of openings 107s that receive signal pins flanked by a row of openings 107g that receive ground pins.

An external shield 109 can surround at least rear housing 103. Shield 109 is preferably made from a suitable solderable material such as a copper alloy. Shield 109 preferably extends along at least three sides of connector 100, the rear wall and the two side walls. For retention on connector 100, shield 109 also includes bent tabs 111 that extend along portions of the bottom wall of connector 100 (i.e., the wall that faces substrate S).

Sub-assemblies 101 contain the ground contacts 113 and signal contacts 115 of connector 100. Ground and signal contacts 113, 115 mate with corresponding ground and signal pins of the mating connector. Differently than shown in U.S. Patent No. 6,116,926, the signal and ground contacts of connector 100 surface mount to a substrate S, typically a multi-layer circuit board (MLB).

The preferred method of surface mounting connector 100 utilizes BGA technology. International Publication number WO 98/15991 (International Patent Application number PCT/US97/18354), describes various connectors and methods of making connectors using BGA technology.

Fusible elements 117 secure to a distal region of contacts 113, 115. Preferably, fusible elements 117 are solder balls fused to contacts 113, 115 during a reflow process. Contacts 113, 115 can have a tab at a distal end region to which solder balls 117 fuse. However, any other manner of securing fusible elements 117 to contacts 113, 115 could be used, such as placing the distal ends of contacts 113, 115 within a pocket (in Figure 4B) of the connector housing.

As shown in Figure 1, substrate S has an array of conductive pads C connected to suitable traces (not shown) to transmit signals or for grounding purposes, for example. 25 Pads C correspond to the array of fusible elements 117 secured to contacts 113, 115 on connector 100. A reflow process, typically subsequent to the reflow process that fused solder balls 117 to contacts 113, 115, fuses solder balls 117 to pads C. Typically, pads C have solder paste (not shown) thereon to accept and to temporarily secure solder balls 117 to substrate S. Typically a squeegee drawn across a stencil (not shown) placed on substrate S provides suitable amounts of solder paste at desired locations. The reflow process fuses solder ball 117 to pad C on substrate S, thus creating an electrical path between contacts 113, 115 and substrate S.

Due to the mechanical loading requirements and the durability of these types of connectors, backplane connectors such as right angle connector 100 may require strain relief features to protect the solder joints formed by solder balls 117. Accordingly, substrate S includes additional conductive pads H at suitable locations, such as surrounding conductive pads C. Conductive pads H preferably match the locations of tabs 111 of external shield 109. In this way, tabs 111 act as hold downs to secure housing 109 to the surface of substrate S.

The reflow process used to secure solder balls 117 to substrate S preferably also secures conductive shield 109 to substrate S. As with conductive pads C, conductive pads H receive solder paste during the squeegee operation. The reflow process fuses shield 109 to substrate S.

Securing conductive shield 109 to substrate S serves as the strain relief for connector 100. Because shield 109 surface mounts to substrate S, the strain relief feature of connector 100 does not interfere with the self-centering characteristic of fusible elements 117 during reflow.

The invention may protect the solder balls from being flattened during reflow because of the weight of the connector. Such flattening may cause unwanted bridging between adjacent solder balls. This may be accomplished through a number of techniques. For example, the connector may include a standoff. The standoff limits the ability of the connector to approach the substrate when the solder balls liquefy. In other words, the standoff prevents the solder balls from being flattened by the weight of the connector and from possibly bridging with adjacent solder balls. The standoffs may be made from any suitable material. Alternatively, as shown in Figure 2B, shield 109 acts as the standoff. Shield 109 allows only a portion of solder balls 117 to extend a distance d beyond shield 109. Distance d is selected so as to limit the flattening of solder balls during the reflow process. As an example, the stand-off could allow up to 40 percent, preferably 30 percent, flattening of the solder balls. Distance d also is selected to limit the bridging of adjacent solder balls during the reflow process. In this way, shield 209 acts like a standoff by preventing connector 100 from skewing on the PCB during reflow.

Figures 3, 4A and 4B display electrical connector 200. Backplane header connector 200 preferably mates with backplane receptacle connector 100. Clearly, connectors 100, 200 are used in a backplane system, for example, to connect a daughtercard to a motherboard.

Connector 200 uses many of the features described in U.S. Patent Application serial number 09/302,027, herein incorporated by reference. Because a detailed discussion of certain features of connector 200 are unnecessary for an understanding of the invention, only a brief summary of these features follows.

Connector 200 includes an insulative housing 201 with apertures therethrough that accept signal pins 203, ground pins 205 and ground shields 207. Signal and ground pins 203, 205 extend from housing 201 and correspond to the arrangement of lead-in apertures 107 in connector 100 for mating with signal and ground contacts 113, 115 (as shown in Figures 1, 2A and 2B). Ground shields 207 remain within housing 201, engage ground pins 205 and act to surround signal pins 203.

An external shield 209 can surround housing 201. Shield 209 preferably is made from a suitable solderable material such as a copper alloy. As shown in Figures 3, 4A, and 4B, shield 209 can extend along the side walls of connector 200. For retention on connector 200, shield 209 also includes bent tabs 211 that extend along portions of the bottom wall of connector 200 (*i*.*e*., the wall that faces substrate S).

As with connector 100 (as shown in Figures 1,2A and 2B), connector 200 surface mounts to substrate S, preferably using the BGA technology discussed in International Publication number WO 98/15991. Fusible elements 213 secure to a distal region of contacts 203, 205. Preferably, fusible elements 213 are solder balls fused to contacts 203, 205 during a reflow process. Contacts 203, 205 can have a tab at the distal region to which solder balls 213 fuse. However, any other manner of securing fusible elements 213 to contacts 203, 205 may be used, such as a pocket 215 in the bottom surface of connector housing 201 (as shown in Figure 4B).

As shown in Figure 3, substrate S has an array of conductive pads C connected to suitable traces (not shown) to transmit signals or for grounding purposes, for example. Pads C correspond to the array of fusible elements 213 secured to contacts 203, 205 on connector 200.

A reflow process, typically subsequent to the reflow process that fused solder balls 213 to contacts 203, 205, fuses solder balls 213 to pads C. Typically, pads C have solder paste (not shown) thereon to accept and to temporarily secure solder balls 213 to substrate S. Typically a squeegee drawn across a stencil (not shown) placed on substrate S provides suitable amounts of solder paste at desired locations. The reflow process fuses solder ball 213 to pad C on substrate S, thus creating an electrical path between contacts 203, 205 and substrate S.

As with connector 100 (as shown in Figures 1, 2A and 2B), connector 200 may require strain relief features to protect the solder joints formed by solder balls 213. Accordingly, substrate S includes additional conductive pads H at suitable locations, such as surrounding conductive pads C. Conductive pads H preferably match the locations of tabs 211 of external shield 209. In this way, tabs 111 act as hold downs to secure housing 109 to the surface of substrate S.

The reflow process used to secure solder balls 213 to substrate S preferably also secures conductive shield 209 to substrate S. As with conductive pads C, conductive pads H receive solder paste during the squeegee operation. The reflow process fuses shield 209 to substrate S.

Securing conductive shield 209 to substrate S serves as the strain relief for connector 200. Because shield 209 surface mounts to substrate S, the strain relief feature of connector 200 does not interfere with the self-centering characteristic of fusible elements 213 during reflow.

Figure 4B shows connector 200 with an alternative housing embodiment. In particular, Figure 4B shows connector 200 with a one-piece continuous housing structure 216. In addition, housing 216 includes ball pockets 215 for receiving solder paste and solder balls 213. The pockets also receive the mounting portion of contacts 203,205.

As previously discussed with reference to connector 100 (as shown in Figures 1, 2A, and 2B), the invention may protect the solder balls from being flattened during reflow because of the weight of the connector. Such flattening may cause unwanted bridging between adjacent solder balls. This may be accomplished through a number of techniques. For example, the connector may include a standoff. The standoff limits the ability of the connector to approach the substrate when the solder balls liquefy. In other words, the standoff prevents the solder balls from being flattened by the weight of the connector and from bridging with adjacent solder balls. The standoffs may be made from any other suitable material. As shown in Figure 2B, shield 209 allows only a portion of the solder balls to extend a distance beyond shield 209. The distance is selected so as to limit the flattening of solder balls during the reflow process. The distance also is selected to limit the bridging of adjacent solder balls during the reflow process. In this way, shield 209 acts like a standoff by preventing connector 200 from skewing on the PCB during reflow.

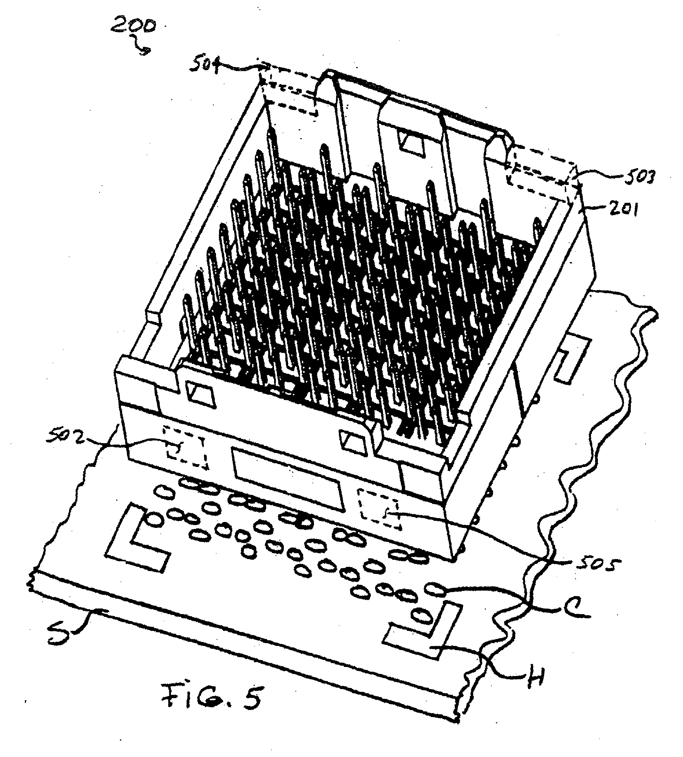

Figure 5 is another example of how the invention ensures that the BGA connector remains substantially parallel to the substrate during reflow. As discussed with reference to connectors 100 and 200, the BGA connector is attached to the substrate by heating the solder balls until the solder melts and becomes fused to the conductive-pads on the substrate. The surface tension of the solder centers the connector on the traces of the substrate. However, in applications where the connector must be manufactured in an unbalanced state (*i*.*e*., the connector has more mass on one side of the solder then the other side), the connector may become skewed with respect to the substrate during the reflow process. As a result, certain of the solder joints may fail under a less than nominal mechanical force. Also, the skew may cause undesired bridging of adjacent solder balls. The invention ensures that the BGA connector remains substantially parallel to the substrate during reflow.

As shown in Figure 5, portions of housing 201 on connector 200 (shown dashed for purposes of clarity) may be added and/or removed to allow the mass of connector 200 to be balanced evenly over the ball grid array. In particular, portions 502 and 505 may be removed from heavier sections of housing 201. Portions 503 and 504 may be added to lighter sections of housing 201. Although Figure 5 shows portions 502-505 in certain locations, it should be appreciated that the location, as well as the size and weight of portions 502-505 will vary depending upon the physical characteristics of connector 200.

Although Figure 5 illustrates balancing connector 200 on the substrate by modifying the physical characteristics of the connector, it should be appreciated that the invention is not so limited. The invention may accomplish such balancing using a number of techniques. For example, an external force may be applied to certain areas of connector 200 during the reflow process. The magnitude of such a force would be determined so as to overcome the skewed relation of connector 200 and substrate S, caused by the imbalance of the housing over the ball grid array. In another embodiment, a similar force may be applied to substrate S, in addition to or instead of the connector. Therefore, the invention includes any technique that overcomes the inherent imbalance of the connector over its ball grid array, and allows the connector to be substantially parallel with the attached substrate after reflow. Although the balancing aspect of the invention was discussed with reference to connector 200, it should be appreciated that such balancing may be applied to any connector, including receptacle connector 100 (as shown in Figures 1, 2A and 2B), for example.

While the invention has been described in connection with the preferred embodiments of the various figures, it is to be understood that other similar embodiments may be used or modifications and additions may be made to the described embodiment for performing the same function of the invention without deviating therefrom. Therefore, the invention should not be limited to any single embodiment, but rather construed in breadth and scope in accordance with the recitation of the appended claims.

## Claims

1. An electrical connector mountable to a substrate, said connector having an array of fusible elements and exhibiting an unbalance relative to said fusible elements (117), wherein the connector further comprises a feature on said connector (200) that prevents said unbalance from causing an undesired skewing of said connector (200) when mounting said connector (200) to the substrate (S), said feature comprising a standoff (209) **characterized in that** the feature further comprises an area of material (502, 505) removed from a housing (216) of said connector.

2. An electrical connector according to claim 1, **characterized in that** said connector is an array connector (200) having a plurality of fusible elements that are able to support a nominal mass without an undesired flattening of said fusible elements (117), said nominal mass being less than a mass of said connector, wherein said feature on said connector (200) prevents undesired flattening of said fusible elements (117).

3. A method of securing an electrical connector (100) to a substrate (S) according to claim 1, said connector having an array of fusible elements and exhibiting an unbalance relative to said fusible elements, comprising:
providing an electrical connector having a contact (113, 115) and a hold down (111);
providing a substrate (S);
mounting said contact (113, 115) to said substrate (S);
balancing said electrical connector (113, 115) on said substrate such that said electrical connector (100) remains substantially parallel to said substrate (S) during forming of first and second solder joints (117), wherein said balancing comprises removing material from said electrical connector (113, 115).

4. The method of claim 3, **characterized in that** said balancing comprises adding material to said electrical connector (113, 115).

5. The method according to any of claims 3 or 4, **characterized in that** said securing said hold down (111) comprises:
providing a shield (109) to said connector (113, 115); and
securing said shield (109) to said substrate (S).

6. The method as recited in claim 3, **characterized in that** said electrical connector (113, 115) is a ball grid array connector.

7. The method as recited in claim 3, **characterized in that** said securing comprises soldering said hold down (111) to said substrate (S).

## Patentansprüche

1. Elektrischer Steckverbinder, welcher sich zur Montage auf einem Substrat eignet, mit einer Anordnung schmelzbarer Elemente, wobei der Verbinder eine Dysbalance bezüglich der schmelzbaren Elemente (117) aufweist, wobei der Verbinder ferner ein Mittel auf dem Verbinder (200) aufweist, welches verhindert, dass diese Dysbalance ein unerwünschtes Schiefaufsitzen des Verbinders (200) bewirkt, wenn der Verbinder (200) auf dem Substrat (S) montiert wird, wobei das Mittel einen Ständer (209) aufweist, **dadurch gekennzeichnet, dass** das Mittel ferner einen Materialbereich (503, 505) aufweist, welches von einem Gehäuse (216) des Verbinders entfernt worden ist.

2. Elektrischer Verbinder nach Anspruch 1, **dadurch gekennzeichnet, dass** der Verbinder ein Matrixverbinder (200) ist mit einer Mehrzahl schmelzbarer Elemente, die in der Lage sind, eine nominale Masse zu tragen, ohne eine unerwünschte Abflachung der schmelzbaren Elemente (117) zu bewirken, wobei die nominale Masse kleiner ist als die Masse des Verbinders und wobei das Mittel auf dem Verbinder (200) eine unerwünschte Abflachung der schmelzbaren Elemente (117) verhindert.

3. Verfahren zum Befestigen eines elektrischen Verbinders (100) auf einem Substrat (S) nach Anspruch 1, wobei der Verbinder eine Anordnung schmelzbarer Elemente aufweist und eine Dysbalance bezüglich der schmelzbaren Elemente aufweist mit folgenden Schritten:
Vorsehen eines elektrischen Verbinders mit folgenden Schritten:
Vorsehen eines elektrischen Verbinders mit einem Kontakt (113, 115) und einer Befestigung (111);
Vorsehen eines Substrates (S);
Montieren des Kontakts (113, 115) auf dem Substrat (S); Ausbalancieren des elektrischen Verbinders (113, 115) auf dem Substrat derart, dass der elektrische Verbinder (100) im Wesentlichen parallel zu dem Substrat (S) angeordnet ist, während erste und zweite Lötverbindungen (117) gebildet werden, wobei das Ausbalancieren umfasst, dass Material von dem elektrischen Verbinder (113, 115) entfernt wird.

4. Verfahren nach Anspruch 3, **dadurch gekennzeichnet, dass** das Ausbalancieren eine Materialzuführung zum elektrischen Verbinder (113, 115) umfasst.

5. Verfahren nach einem der Ansprüche 3 oder 4, **dadurch gekennzeichnet, dass** das Sichern der Befestigung (111) umfasst:
Vorsehen einer Abschirmung (109) am Verbinder (113, 115); und
Sichern der Abschirmung (109) am Substrat (S).

6. Verfahren nach Anspruch 3, **dadurch gekennzeichnet, dass** der elektrische Verbinder (113, 115) ein Kugelgittermatrixverbinder ist.

7. Verfahren nach Anspruch 3, **dadurch gekennzeichnet, dass** das Sichern ein Verlöten der Befestigung (111) auf dem Substrat (S) umfasst.

## Revendications

1. Un connecteur électrique pouvant être monté sur un substrat, ledit connecteur possédant une réseau d'éléments fusibles et présentant un déséquilibre par rapport aux dits éléments fusibles (117), dans lequel le connecteur comprend en outre une caractéristique sur ledit connecteur (200) qui empêche ledit déséquilibre de provoquer une inclinaison non désirée dudit connecteur (200) lors du montage dudit connecteur (200) sur le substrat (S), ladite caractéristique comprenant un espaceur (209) **caractérisé en ce que** la caractéristique comprend en outre une zone de matériau (502, 505) supprimé d'un boîtier (216) dudit connecteur.

2. Un connecteur électrique selon la revendication 1, **caractérisé en ce que** ledit connecteur est un connecteur à réseau (200) possédant une pluralité d'éléments fusibles qui sont capables de supporter une masse nominale sans aplatissement non désiré desdits éléments fusibles (117), ladite masse nominale étant inférieure à une masse dudit connecteur, dans lequel ladite caractéristique sur ledit connecteur (200) empêche l'aplatissement non désiré desdits éléments fusibles (117).

3. Un procédé de fixation d'un connecteur électrique (100) sur un substrat (S) selon la revendication 1, ledit connecteur possédant une réseau d'éléments fusibles et présentant un déséquilibre par rapport aux dits éléments fusibles, comprenant:
la fourniture d'un connecteur électrique possédant un contact (113, 115) et un élément de retenue (111);
la fourniture d'un substrat (S);
le montage dudit contact (113, 115) sur ledit substrat (S);
l'équilibrage dudit connecteur électrique (113, 115) sur ledit substrat de sorte que ledit connecteur électrique (100) reste en grande partie parallèle au substrat (S) durant la formation du premier et du second joints de soudure (117), dans lequel ledit équilibrage comprend la suppression de matériau dudit connecteur électrique (113, 115).

4. Le procédé de la revendication 3, **caractérisé en ce que** ledit équilibrage comprend l'ajout de matériau au dit connecteur électrique (113, 115).

5. Le procédé selon n'importe laquelle des revendications 3 ou 4, **caractérisé en ce que** ladite fixation de l'élément de retenue (111) comprend:
la fourniture d'un blindage (109) sur ledit connecteur (113, 115);
et la fixation dudit blindage (109) sur ledit substrat (S).

6. Le procédé selon la revendication 3, **caractérisé en ce que** ledit connecteur électrique (113, 115) est un connecteur de réseau de grille à billes.

7. Le procédé selon la revendication 3, **caractérisé en ce que** ladite fixation comprend le soudage de l'élément de retenue (111) sur ledit substrat (S).
